# EUROPEAN PATENT SPECIFICATION

(11) **EP 0 958 255 B1**
(45) Date of publication and mention of the grant of the patent: **23.08.2006**
(21) Application number: 97944297.7
(22) Date of filing: 27.08.1997
(51) Int. Cl.: C03C 3/06, C03C 3/076, C03C 4/00, C03C 23/00

(54) **SILICA WITH LOW COMPACTION UNDER HIGH ENERGY IRRADIATION**
QUARTZ MIT NIEDRIGER KOMPAKTIERUNG UNTER HOCHENERGIEBESTRAHLUNG
SILICE A FAIBLE COMPACTION SOUS RAYONNEMENT A GRANDE ENERGIE

(30) Priority: 29.08.1996 US 24995 P
(43) Date of publication of application: 24.11.1999
(73) Proprietor: Corning Incorporated, Corning, NY 14831 (US)
(72) Inventor: BORRELLI, Nicholas, F., Elmira, NY 14905 (US); SEWARD, Thomas, P., Elmira, NY 14901 (US); SMITH, Charlene, Corning, NY 14830 (US)
(74) Representative: Marchant, James Ian
(86) International application number: PCT/US1997/015233
(87) International publication number: WO 1998/008775

(56) References cited:
- EP-A- 0 525 984
- US-A- 3 933 454
- US-A- 4 789 389
- US-A- 5 043 002
- US-A- 5 364 433
- US-A- 5 523 266
- US-A- 5 547 482

## Description

### FIELD OF THE INVENTION

The invention relates to stepper lens from fused silica having low compaction under high energy irradiation, particularly adaptable for use in photolithography applications at wavelengths of 193 and 248 nm.

### BACKGROUND OF THE INVENTION

Fused silica is highly relevant to such applications as windows and mirrors used in outer space, and increasingly, it is becoming relevant to optical elements for deep ultraviolet photolithography. However, it is generally known that prolonged exposure of fused silica to intense deep ultraviolet radiation of the type utilized in photolithography leads to optical damage which is generally manifested in the form of changes in the optical and physical properties of the glass.

One form of optical damage observed in fused silica glass is a physical densification or compaction of the exposed regions of the glass. Compaction is generally observed by interferometry where the alteration of the optical phase front is measured through the damaged regions, and is reported as optical path difference, the product of refractive index and path length, in ppm or waves of 633 nm light. Thus, the optical phase front of stepper lens elements for photolithographic applications which utilize deep ultraviolet wavelengths at 193 and 248 nm for high resolution microcircuit fabrication may become altered due to optical modification as a consequence of prolonged exposure. Even though small changes in the optical phase front produced by the effect of exposure over the life of the lens barrel are expected, at present the maximum acceptable change is not known. What is known however, is that there is a relationship between alterations in fused silica and the ultimate effect of such changes on the wavefront.

The question of what factors contribute to the propensity of various silica materials to optical damage when exposed to high energy laser irradiation is not settled and several possible answers have been advanced in the literature.

Recently, in WO 980 7053 it was suggested that radiation-caused optical damage can be minimized or eliminated by precompacting fused silica by such processes as hot isostatic pressing and by high energy pre-exposure in order to thereby desensitize the glass to subsequent high energy irradiation during actual use.

There continues to be a need for laser damage resistant fused silica. Accordingly, it is the object of the present invention to provide a fused silica stepper lens which is resistant to laser-induced damage, specifically defined as densification.

### SUMMARY OF THE INVENTION

The present invention relates to a stepper lens resistant to compaction made from fused silica glass, the stepper lens exhibiting a phase front distortion of less than 0.095 ppm when exposed to a dose of high intensity excimer radiation having a wavelength of 248 nm or 193 nm and a dose of I²N = 6.3 x 10¹⁰.

The present invention also relates to a method of making a fused silica stepper lens which is resistant to compaction when exposed to high intensity excimer radiation, said method comprising the steps of:
(a) depositing on a starting member a coating of flame hydrolysis-produced silica soot to form a soot preform;
(b) consolidating the soot preform to form a dense silica glass layer free from particle boundaries; and
(c) forming said dense glass layer into a stepper lens;
said consolidation step comprising heating said soot preform to a temperature within the consolidation temperature range for a time sufficient to cause said soot particles to fuse and form a dense glass layer, and simultaneously subjecting the soot preform to a stream of a substantially dry, hydrogen-free, chlorine containing atmosphere, to thereby produce a fused silica stepper lens that exhibits a phase front distortion of less than 0.095 ppm when exposed to a dose of high intensity excimer radiation having a wavelength of 248 nm or 193 nm and a dose I²N = 6.3 X 10¹⁰.

### BRIEF DESCRIPTION OF THE DRAWINGS

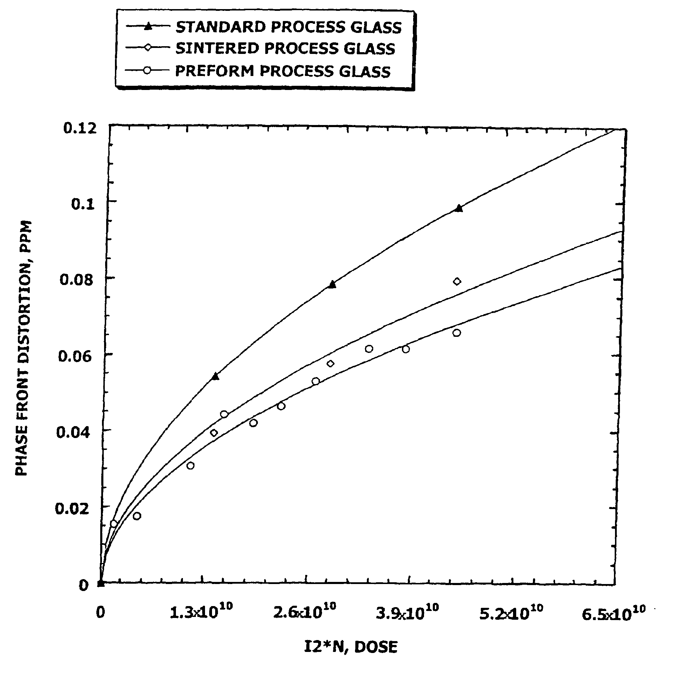

The figure compares the phase front distortions of a standard fused silica with the phase front distortions observed in two inventive stepper lens fused silica.

### DETAILED DESCRIPTION OF THE INVENTION

Ideally, fused silica glass for photolithographic applications should be resistant to laser-induced optical damage. To be resistant to laser-induced optical damage, stepper lenses for photolithographic applications should be resistant to laser-induced absorption and compaction. However, most fused silica stepper lenses available today have shown a tendency to optically deteriorate after prolonged exposure to excimer laser radiation. We have demonstrated that stepper lenses made from fused silica glasses produced by certain processes are more resistant to laser-induced compaction than are lenses made by conventional stepper lens manufacturing methods such as the boule process.

Structural change in fused silica has at least two ramifications: (1) a geometric change in the densified region, which gives rise to a decrease in the optical path length; and (2) an increase in the refractive index of the fused silica caused by an increase in density. These two effects result in a net change (increase) in the optical path length (optical path difference, OPD).

Typically, density increases caused by high energy irradiation are very small (in the range of about 1 to 50 ppm), so that direct measurements of the absolute density range can be impractical. For the purpose of this work we have used interferometric measurements to characterize relative density changes across fused silica samples, measuring densified (exposed) and undensified (non-exposed) regions of each sample.

Examples of useful processes include, (1) the flame hydrolysis process described in U.S. Patents 5,043,002 and 3,933,454 both of which are sometimes referred to herein as the waveguide process; and (2) the sol-gel method described in U.S. Patent 4,789,389 which is sometimes referred to herein as the sintered process.

One method of making fused silica lenses which are resistant to laser-induced compaction is by the flame hydrolysis process. In a conventional flame hydrolysis method, a coating of flame hydrolysis-produced glass soot is deposited on a starting member to form a soot preform. The preform is consolidated to form a dense glass layer which can then be formed into a desired shape. In the consolidation step, the soot preform is subjected to a temperature if the consolidation temperature range for a time sufficient to permit the soot particles to fuse and consolidate, thereby forming a dense glass layer which is free from particle boundaries. Alternatively, such glass can be made using an improved flame hydrolysis process as described in U.S. 3,933,454. In the consolidation step of the improved process, the soot preform is heated to a temperature within the consolidation temperature range for a time sufficient to cause the soot particles to fuse and form a dense glass layer. Simultaneous with the consolidation, the glass is subjected to a stream of a substantially dry chlorine containing atmosphere.

Generally, in the fused silica process a vaporous stream of silicon-containing compound is converted, through thermal decomposition with oxidation or flame hydrolysis, to SiO₂. The gas stream is then passed into the flame of a combustion burner to form amorphous particles of fused SiO₂ which are then deposited onto a support and consolidated to form fused silica. To produce the inventive stepper lens, the amorphous particles are consolidated in a chlorine-containing environment to purify the glass. In a particularly useful modified process, the deposit of amorphous particles are consolidated in a He/HCl-containing atmosphere to form a transparent glass body.

Useful silicon-containing compounds for forming fused silica glass are well known in the industry such as disclosed collectively in U.S. Patent No. 3,393,454; 4,789,389; 5,043,002; 5,152,819; and 5,154,744. Preferably, the silicon-containing gaseous feedstock includes compounds that can be oxidized by flame hydrolysis or pyrolysis, to produce transparent, high-purity silica glass articles. However, for safety and environmental reasons, halide-free, cylcosiloxane compounds are preferred.

Examples of useful halide-free silicon-containing compounds include cyclosiloxane compounds, preferably, polymethylsiloxane such as hexamethyldisiloxane, polymefihylcyclosiloxane, and mixtures of these. Examples of particularly useful polymethylcyclosiloxane, include, hexamethylcyclotrisiloxane, decamethylcylcopentasiloxane, octamethylcyclotetrasiloxane and mixtures of these.

In addition to polymethylsiloxanes, organosilicon materials satisfying the following three criteria can also be used to produce the inventive stepper lens:
(1) an operable organosilicon-Z compound (Z is an element of the Periodic Table) will have a Si-Z bond dissociation energy that is no higher than that of the Si-O bond;
(2) an operable organosilicon-Z compound will exhibit a significant vapor pressure at temperatures below 250° C and a boiling point no higher than 350°C; and, in the in terest of safety,
(3) an operable organosilicon-Z compound will, upon pyrolysis and/or hydrolysis, yield decomposition products besides SiO₂ which are deemed to be environmentally safe or the emissions are below acceptable governmental standards.

Three groups of compounds which have previously been found to be especially useful are categorized below according to the bonding arrangement in the basic structure:
(1) organosilicon-oxygen compounds, having a basic Si-O-Si structure, in particular linear siloxanes wherein an oxygen atom and a single element or group of elements, such as a methyl group, is bonded to the silicon atom;
(2) organosilicon-nitrogen compounds, having a basic Si-N-Si structure, such as aminosilanes, linear silazanes, and cyclosilazanes, wherein a nitrogen atom and a single element or group of elements are bonded to the silicon atom; and
(3) siloxasilazanes, having a basic Si-N-Si-O-Si structure, wherein a nitrogen atom and an oxygen atom are bonded to the silicon atom.

Other useful halide-free silicon-containing compounds for the method of the invention include octamethyltrisiloxane (an operable linear siloxane), aminosilanes such as tris (trimethylsilyl) ketenimine, linear silazanes such as nonamethyltrisilazane, cyclosilazanes such octamethylcyclotetrasilazane, and siloxasilazanes such as hexamethyl-cyclotrisiloxazane.

In one particularly useful method of the invention, halide-free, cyclosiloxane compound such as octamethylcyclotetrasiloxane (OMCTS), represented by the chemical formula, ---[SiO(CH₃)₂]₄---, is used as the feedstock in the vapor deposition processes such as used in making high purity fused silica for optical waveguide applications.

The invention is further illustrated below by reference to the figure in which the phase front distortion (ppm) is plotted versus dose of exposure, I²N; where I is the laser intensity, and N is the number of pulses. The reciprocity of the dose parameter allows one to calculate the total exposure dose that a sample will see without regard to the intensity or number of pulses and, using the equation given on the figure, predict the densification. What this means in the practical sense is that the quantity is what is important, not how the sample gets there.

The application for this material is photolithography, therefore, in the following sections we clearly demonstrate that the sol gel (sintered) and waveguide (preform) processes produce fused silica glasses which are less compacting over the predicted lifetime of a lithographic lens than fused silica lenses made by the standard (boule) process. In the figure, the result for the fused silica sample produced from the standard boule process is represented by triangles, the sintered process by diamonds, and the preform process by circles. Sample geometries and laser exposure arrangements were the same for all samples studied.

The plotted phase front distortion for the sintered process was obtained directly from interferometric data. For the preform process, the peak-to-valley phase front distortion was calculated from birefringence measurements using the conversion reported in Borrelli, Smith, Allan, and Seward, "Densification of fused silica under 193-nm excitation", J. Opt. Soc. Am. B/Vol. 14, No. 7/July 1997, 1606, and Allan, Smith, Borrelli, and Seward, "193-nm excimer-loser-induced densification of fused silica", OPTICS LETTERS/Vol. 21, No. 24/ December 15, 1996, 1960. For the standard fused silica glass we used samples of Corning's Code HPFS® fused silica (Corning, New York), which had been optimized for deep ultraviolet transmittance and optical homogeneity.

In the figure we have shown change in phase front data from 0 to about 0.12 ppm, which is reasonably the practical limits of distortion for photolithographic applications. The figure compares the measured compaction between fused silica made by the standard boule process (triangles) and stepper lens made from fused silica made by the sintered (diamonds) and waveguide (open circles) processes over the lifetime of a lens. For this purpose, we have assumed that the optical elements will be subjected to a fluence (I) of 0.5 mJ/cm²/pulse for 8 years. We have further assumed that the laser will have a repetition rate of 1000Hz and the stepper containing the lens will be run for 7 days a week, 24 hours a day, 365 days a year, yielding a lifetime dose (I²N) of 6.3 x 10¹⁰. Inspection of the graph shows that fused silica made by the standard process exhibits about 0.12 ppm of distortion at this dose, while fused silica made by the sintered and waveguide processes exhibit phase front distortions of only 0.09 and 0.08 ppm, respectively, which are less that 0.095 ppm of distortion. It is significant to note that the curves for the sintered and waveguide samples are below the curve for the standard process glass over the entire lifetime of the fused silica. The graph also shows that over the dosage range, the phase front distortion of fused silica stepper lenses made by sintered and waveguide processes exhibit a phase front distortion that is about 25% less than the phase front distortion of fused silica stepper lenses made by the standard boule process.

## Claims

1. A stepper lens resistant to compaction made from fused silica glass, **characterized in that** the stepper lens exhibits a phase front distortion of less than 0.095 ppm when exposed to a dose of high intensity excimer radiation having a wavelength of 248 nm or 193 nm and a dose I²N = 6.3 x 10¹⁰.

2. A method of making a fused silica stepper lens which is resistant to compaction when exposed to high intensity excimer radiation, said method comprising the steps of:
(a) depositing on a starting member a coating of flame hydrolysis-produced silica soot to form a soot preform;
(b) consolidating the soot preform to form a dense silica glass layer free from particle boundaries; and
(c) forming said dense glass layer into a stepper lens;
said consolidation step comprising heating said soot preform to a temperature within the consolidation temperature range for a time sufficient to cause said soot particles to fuse and form a dense glass layer, and simultaneously subjecting the soot preform to a stream of a substantially dry, hydrogen-free, chlorine containing atmosphere, to thereby produce a fused silica stepper lens that exhibits a phase front distortion of less than 0.095 ppm when exposed to a dose of high intensity excimer radiation having a wavelength of 248 nm or 193 nm and a dose I²N = 6.3 X 10¹⁰.

3. The method according to claim 2, wherein the silica soot is produced by flame hydrolysis of a vaporous stream of a silicon-containing compound.

4. The method according to claim 3, wherein the silica soot is produced by flame hydrolysis of an organosilicon compound having a basic Si-O-Si structure.

5. The method according to claim 4, wherein the silica soot is produced by flame hydrolysis of a cyclosiloxane or a linear siloxane.

6. The method according to claim 3, wherein the silica soot is produced by flame hydrolysis of an organosilicon-nitrogen compound having a basic Si-N-Si structure.

7. The method according to claim 3, wherein the silica soot is produced by flame hydrolysis of a siloxasilazane compound having a basic Si-N-Si-O-Si structure.

8. The method according to claim 2, wherein the silica soot is produced by flame hydrolysis of an organosilicon-Z compound wherein:
(1) Z is an element that has a Si-Z bond dissociation energy that is no higher than that of the Si-O bond; and
(2) the organosilicon-Z compound exhibits a significant vapor pressure at temperatures below 250°C and has a boiling point no higher than 350°C.

## Patentansprüche

1. Stepper-Linse, welche gegenüber Kompaktierung resistent ist, hergestellt aus Quarzglas, **dadurch gekennzeichnet, dass** die Stepper-Linse eine Phasenfrontverzeichnung von weniger als 0,095 ppm aufweist, wenn sie einer Dosis von hochintensiver Excimer-Strahlung, welche eine Wellenlänge von 248 nm oder 193 nm und eine Dosis I²N = 6,3 x 10¹⁰ besitzt, ausgesetzt ist.

2. Verfahren zum Herstellen einer Quarzglas-Stepper-Linse, welche gegenüber Kompaktierung widerstandsfähig ist, wenn diese einer Excimer-Strahlung hoher Intensität ausgesetzt ist, wobei dieses Verfahren die Schritte aufweist von:
(a) Aufbringen einer Beschichtung aus mit Flammenhydrolyse hergestelltem Siliciumdioxidruß auf einem Ausgangselement, um eine Rußvorform zu bilden;
(b) Konsolidieren der Rußvorform, um eine dichte Quarzglasschicht frei von Partikelgrenzen zu bilden; und
(c) Bilden der dichten Glasschicht in eine Stepper-Linse; wobei der Konsolidierungsschritt das Erhitzen der Rußvorform auf eine Temperatur innerhalb des Konsolidierungstemperaturbereiches aufweist, für eine Zeit, welche ausreicht, um die Rußpartikel zum Schmelzen zu bringen und um eine dichte Glasschicht zu bilden, und gleichzeitiges Aussetzen der Rußvorform einer Strömung aus im Wesentlichen trockener, wasserstofffreier, chlorhaltiger Atmosphäre, um dadurch eine Quarzglas-Stepper-Linse herzustellen, welche eine Phasenfrontverzeichnung von weniger als 0,095 ppm aufweist, wenn diese einer Dosis von Excimer-Strahlung mit hoher Intensität ausgesetzt ist, welche eine Wellenlänge von 248 nm oder 193 nm und eine Dosis I²N gleich 6, 3 x 10¹⁰ besitzt.

3. Verfahren nach Anspruch 2, in welchem der siliciumdioxidruß durch Flammenhydrolyse eines Dampfstromes einer Silicium-haltigen Verbindung hergestellt wird.

4. Verfahren nach Anspruch 3, in welchem der Siliciumdioxidruß durch Flammenhydrolyse einer Organosiliciumverbindung hergestellt wird, welche eine Si-O-Si-Grundstruktur besitzt.

5. Verfahren nach Anspruch 4, in welchem der Siliciumdioxidruß durch Flammenhydrolyse eines cyclosiloxans oder eines linearen Siloxans hergestellt wird.

6. Verfahren nach Anspruch 3, in welchem der Siliciumdioxidruß durch Flammenhydrolyse einer Organosilicium-Stickstoff-Verbindung hergestellt wird, welche eine Si-N-Si-Grundstruktur besitzt.

7. Verfahren nach Anspruch 3, in welchem der Siliciumdioxidruß durch Flammenhydrolyse einer Siloxasilazanverbindung hergestellt wird, welche eine Si-N-Si-O-Si-Grundstruktur besitzt.

8. Verfahren nach Anspruch 2, in welchem der Siliciumdioxidruß durch Flammenhydrolyse einer Organosilicium-z-Verbindung hergestellt wird, in welchem:
(1) z ein Element ist, das eine Si-Z-Bindungs-Dissoziationsenergie besitzt, welche nicht höher als die der Si-O-Bindung ist; und
(2) die organosilicium-Z-Verbindung einen signifikanten Dampfdruck bei Temperaturen unterhalb von 250°C und einen Siedepunkt nicht höher als 350°C aufweist.

## Revendications

1. Une lentille de photorépéteur résistante au tassement formée de verre de silice fondue, **caractérisée en ce que** la lentille de photorépéteur présente une distorsion de front de phase de moins de 0,095 partie par million lorsqu'elle est exposée à une dose de rayonnement de laser à excimère de forte intensité ayant une longueur d'onde de 248 nm ou de 193 nm et une dose I²N = 6,3 x 10¹⁰.

2. Un procédé pour la réalisation d'une lentille de photorépéteur en silice fondue qui est résistante au tassement lorsqu'elle est exposée à un rayonnement de laser à excimère de forte intensité, ledit procédé comprenant les opérations consistant :
(a) à déposer sur un élément de départ un revêtement de suie de silice préparée par hydrolyse à la flamme pour former une préforme de suie ;
(b) à consolider la préforme de suie pour former une couche de verre de silice dense exempte de joints entre particules ; et
(c) à transformer ladite couche de verre dense en une lentille de photorépéteur,
ladite opération de consolidation comprenant un chauffage de ladite préforme de suie à une température comprise dans le domaine de températures de consolidation pendant une durée suffisante pour faire fusionner lesdites particules et leur faire former une couche de verre dense, et la soumission simultanée de la préforme de suie à un courant d'une atmosphère sensiblement anhydre, dépourvue d'hydrogène et contenant du chlore pour produire ainsi une lentille de photorépéteur en silice fondue qui présente une distorsion de front de phase de moins de 0,095 partie par million lorsqu'elle est exposée à une dose de rayonnement de laser à excimère de forte intensité ayant une longueur d'onde de 248 nm ou de 193 nm et une dose I²N = 6,3 x 10¹⁰.

3. Le procédé de la revendication 2, dans lequel la suie de silice est produite par hydrolyse à la flamme d'un courant de vapeur d'un composé silicié.

4. Le procédé de la revendication 3, dans lequel la suie de silice est produite par hydrolyse à la flamme d'un composé organosilicié ayant une structure de base de la forme Si-O-Si.

5. Le procédé de la revendication 4, dans lequel la suie de silice est produite par hydrolyse à la flamme d'un courant d'un cyclosiloxane ou d'un siloxane linéaire.

6. Le procédé de la revendication 3, dans lequel la suie de silice est produite par hydrolyse à la flamme d'un composé organosilicié azoté ayant une structure de base de la forme Si-N-Si.

7. Le procédé de la revendication 3, dans lequel la suie de silice est produite par hydrolyse à la flamme d'un composé siloxasilazane ayant une structure de base de la forme Si-N-Si-O-Si.

8. Le procédé de la revendication 2, dans lequel la suie de silice est produite par hydrolyse à la flamme d'un composé Z-organosilicié dans lequel :
(1) Z est un élément qui présente une énergie de dissociation de liaison Si-Z non supérieure à celle de la liaison Si-O ; et
(2) le composé Z-organosilicié présente une pression de vapeur appréciable à des températures inférieures à 250 °C et a un point d'ébullition non supérieur à 350 °C.
